(19) Europäisches Patentamt
European Patent Office
Office européen des brevets

(11) EP 1 091 395 A1

(12) EUROPEAN PATENT APPLICATION

(43) Date of publication:
**11.04.2001 Bulletin 2001/15**

(51) Int Cl.[7]: **H01L 21/306**, B08B 3/08, C11D 7/26, C11D 7/32

(21) Application number: **99870203.9**

(22) Date of filing: **30.09.1999**

(84) Designated Contracting States:
**AT BE CH CY DE DK ES FI FR GB GR IE IT LI LU MC NL PT SE**
Designated Extension States:
**AL LT LV MK RO SI**

(71) Applicants:
- **INTERUNIVERSITAIRE MICROELEKTRONICA CENTRUM VZW 3001 Leuven (BE)**
- **J.W. Goethe-Universität 60439 Frankfurt/M. (DE)**

(72) Inventors:
- **Vos, Rita 3128 Tremelo (BE)**
- **Mertens, Paul 3150 Haacht (BE)**
- **Kenis, Karine 3010 Kessel-Lo (BE)**
- **Kolbesen, Bernd 61850 Bad Homburg (DE)**
- **Martin, Andreas 60326 Frankfurt Am Main (DE)**
- **Hermann, Harald 60489 Frankfurt Am Main (DE)**
- **Stelter, Hellen 65510 Idstein (DE)**

(74) Representative: **Van Malderen, Joelle et al Office Van Malderen, Place Reine Fabiola 6/1 1083 Bruxelles (BE)**

(54) **A cleaning solution for treating a semiconductor substrate**

(57) The present invention concerns a cleaning solution for treating a semiconductor substrate, said cleaning solution comprising an alkaline compound, water and a chelating agent comprising at least one group with the chemical formula

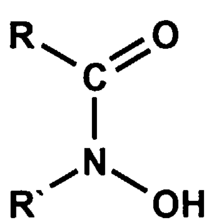

with R and R' selected from the group comprising H and any organic group. Another aspect of the invention is a process for treating a semiconductor substrate comprising the steps of treating said semiconductor substrate with the cleaning solution as described above and drying said semiconductor substrate.

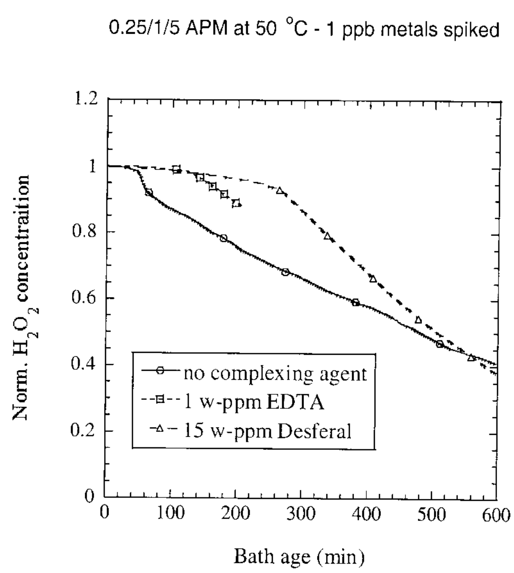


Fig. 2

EP 1 091 395 A1

## Description

### Field of the invention

The invention is situated in the field of products and methods for the cleaning of semiconductor surfaces.

### State of the art

Since the invention of the RCA cleaning by Kern *et al.* in 1965 (W. Kern and D.A.Pautinen, RCA Review 31, 187, 1970) this cleaning cycle has become the most used for semiconductors. The conventional RCA cleaning consists of two steps: an alkaline solution, the so called SC1 solution and an acidic solution, SC2. The SC1 solution is composed of 1 part ammonia ($NH_4OH$), 1 part hydrogen peroxide ($H_2O_2$) and 5 parts ultra pure water ($H_2O$) and is often referred to as APM-cleaning (*i.e.* Ammonia Peroxide Mixture). Originally it was used to remove organic residues by oxidation. Later it has been proven to be very efficient to remove particles.

A drawback of the SC1 solution is, that metals precipitate on silicon surfaces; especially aluminum, iron and zinc have been shown to adsorb strongly on the wafer surface (Mertens *et al.,* 1998). In addition, especially Fe and Cu are found to catalyze the decomposition reaction of the peroxide (Mertens *et al.,* 1997) leading to a decrease in the bath lifetime. In order to remove the metallic surface contamination, the SC2 solution consisting of 1 part hydrochloric acid, 1 part hydrogen peroxide and 6 parts ultra-pure water is used. However, it is expensive to get hydrochloric acid of sufficient quality for the usage in SC2 solution. There is also a risk of re-contaminating the surface with particles. Problems also occur in spray tools due the corrosive behavior of hydrochloric acid.

With the progress in semiconductor manufacturing the requirements concerning particle-, metal contamination and roughness of the silicon surfaces became more stringent. This led to a number of variations of the RCA clean.

The potential problems related to the SC2 and the consideration to reduce process time and equipment by leaving out this acidic step led to the development of single-stage cleaning procedures. This can be done by using chemicals with reduced amount of metallic impurities. For that purpose, advanced purification procedures are established for obtaining ultra-pure water, ammonia and hydrogen peroxide. However, these chemicals are very expensive and the purity is not always assured when they are used in a cleaning bath. Moreover, the cleaning solution is not very robust with respect to metal contamination from the semiconductor substrate and from the hardware.

Besides this, the introduction of an extra step in the cleaning cyclus implies extra hardware, e.g. the SC2-tank and a rinse tank need to be used, and more chemicals. Leaving out this extra step will results in a reduction of the hardware cost and a reduction of the amount of chemicals used in the cleaning cycle.

US 5,290,361 and US 5,302,311 describes an aqueous hydrogen peroxide solution further comprising a chelating compound containing phosphonic acid groups and showing chelating ability. Cleaning solution comprising phosphonic acid groups are not effective in removing or supressing Al from the substrate. Moreover, enhanced deposition of Cu has been measured. This makes the cleaning solutions less suitable.

The document DE 193 31 363 describes an aqueous cleaning solution comprising a base, hydrogen peroxide and a complex-forming agent, said agent being formed by heterocyclic hydrocarbons with a ring size comprising between 9 and 18 atoms and at least 3 heteroatoms. The cleaning solution results in a good removal of Fe, the removal of Al on the other hand is not effective. An additional disadvantage of those complex-forming agents is the very complex synthesis and purification.

In the present invention, the problems related to removal of metals as mentioned in the prior art, are avoided.

### Aims of the invention

The primary aim of the invention is to provide a new cleaning solution which provokes less or no metal precipitation on the semiconductor surface, possibly even removing metal precipitation from the semiconductor surface. Another aim of the present invention is to provide an efficient APM-cleaning solution having a good robustness with respect to metal contamination from the fresh chemicals as well as with respect to metal contamination introduced in the course of its use for cleaning.

A further aim is to provide a new single-step method for cleaning semiconductor surfaces.

### Summary of the invention

In this invention, the problems mentioned in the background of the invention can be avoided.

In a first aspect of the invention, a cleaning solution for treating a semiconductor substrate is described. Said cleaning solution comprises an alkaline compound, water and a chelating agent comprising at least one group with the chemical formula

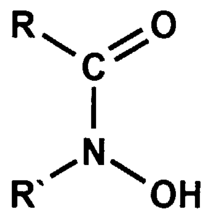

with R and R' selected from the group comprising H and any organic group.

Preferably, said chelating agent comprises 3 groups with the chemical formula

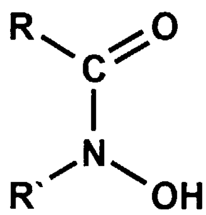

with R and R' selected from the group comprising H and any organic group. Preferably, said chelating agent is a desferrioxamine-Fe complex or Desferal ®.

Said organic groups can be H, an organic side chain, a heterocycle or an aromatic structure.

In a first embodiment of this first aspect of the invention, said cleaning solution can additionally comprise an oxidizing compound.

In a further embodiment of this first aspect of the invention, said oxidizing compound is hydrogen peroxide. The weight concentration of said hydrogen peroxide in the solution lies between 0.01 to 30%.

In a further embodiment of this first aspect of the invention, said alkaline compound can be an organic base, ammonia, ammonium hydroxide, tetramethyl ammonium hydroxide or an alkaline solution containing metal ions. The weight concentration of said chelating agent is from 0.01 to 20 %

In a further embodiment of this first aspect of the invention, the weight concentration of said chelating agent in said cleaning solution is from 1 ppt to 1000 ppm.

In a further embodiment of this first aspect of the invention, the weight concentration of said chelating agent in said cleaning solution is from 1 ppt to 1000 ppm.

In a further embodiment of this first aspect of the invention, said cleaning solution comprises ammoniumhydroxide, water and desferrioxamine. Said cleaning solution can further comprise hydrogen peroxide.

In a second aspect of the invention, a process for treating a semiconductor substrate comprising the steps of

- treating said semiconductor substrate with said cleaning solution
- drying said semiconductor substrate is described.

In a first embodiment of the second aspect of the invention, said process for treating a semiconductor substrate comprises the additional step of:

- Rinsing said semiconductor substrate,

wherein said rinsing said semiconductor substrate is performed after step of said treating a semiconductor substrate with said cleaning solution.

In a further embodiment of the second aspect of the invention, said process for treating a semiconductor substrate with said cleaning solution is performed at a temperature range from 5 to 85 degrees Celsius.

In a further embodiment of the second aspect of the invention, said process for treating a semiconductor substrate with said cleaning solution is performed at 50 degrees Celsius.

In a third aspect of the invention, a process for treating a semiconductor substrate comprising the step of:

- treating said semiconductor substrate with any cleaning solution
- treating said semiconductor substrate with a rinsing solution,

wherein said any cleaning solution can be any alkaline cleaning solution and wherein said rinsing solution comprises said chelating agent and water.

**Short description of the drawings**

Figure 1a shows a desferrioxamine-Fe complex,comprising three non-terminal hydroxamate groups.
Figure 1b describes Desferal ®.
Figure 2 draws the peroxide concentration normalized to the initial $H_2O_2$ concentration versus the bath age for a 0.25/1/5 APM mixture at 50°C spiked with different metals and complexing agents.

**Detailed description of the invention**

In relation to the appended drawings the present invention is described in detail in the sequel. It is apparent however that a person skilled in the art can imagine several other equivalent embodiments or other ways of executing the present invention.
The use of APM cleaning mixtures comprising complexing agents offers many advantages. APM-cleaning mixtures comprising a chelating agent according to the present invention are robust with respect to metal contamination coming from the fresh chemicals as well as with respect to metal contamination introduced in the course of its use for cleaning. The robustness of the basic APM process can be improved by the addition of complexing agents which keep the metals in solution and prevent the above mentioned catalysis of the peroxide decomposition.
The invention is related to cleaning solutions for treating semiconductor substrates, comprising water, an alkaline compound and chelating agent(s).
Said cleaning solution can further comprise an oxidizing agent.
A semiconductor substrate can be every possible substrate used in semiconductor processing. Said semiconductor substrate can be a substrate selected from the group, but not limited hereto, comprising a substrate made of silicon, Germanium, Gallium Arsenide, Indium Phosphide,...
The semiconductor substrate be e.g. the substrates as mentioned above covered entirely op partially with a thin film of e.g. an oxide, a nitride, a metal, a polymeric insulating layer, an anti-reflecting coating, a barrier,...
The alkaline compound or base can be every chemical compound with a pH higher than 7. The alkaline compound can be an organic base, ammonia, ammoniumhydroxide, or an alkaline solution containing metal ions such as potassium or sodium. Said organic base can be a quaternary ammonium hydroxide such as tetraalkyl ammonium hydroxide in which the alkyl groups can contain hydroxy- and alkoxy-containing groups with 1 to 4 carbon atoms in the alkyl or alkoxy group. Said organic base can further be an organic amine such as an alkanol amine. Alkanol amines can be 2-aminoethanol, 1-amino 2-propanol, 1-amino 3-propanol. Preferably, the alkaline compounds are tetramethyl ammonium hydroxide, and trimethyl 2-hydroxy ethyl ammonium hydroxide (choline) and ammonium hydroxide.
For ammonium hydroxide, The weight concentration range of the alkaline compound in the cleaning solution are typically but not limited to 0.01-30 %, 0.1-20 % and preferably 0.1-5 % by weight. For other alkaline compounds, the weight concentration range is equivalent, and function of the strength of the alkaline compound.
According to the present invention a chelating agent (hereafter referred to as CA) is added to the cleaning solution. Said chelating agent is an a chemical compound comprising at least one group with the chemical formula

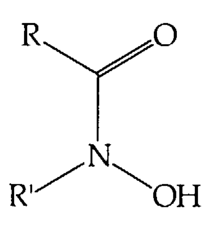

wherein R and R' are selected from the group comprising hydrogen (H) or any organic group.
The COR-NR"OH group is hereafter referred to as hydroxamate group. The hydroxamate group can be in a terminal or non-terminal position in the CA molecule.

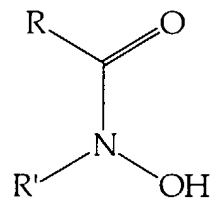

non terminal position

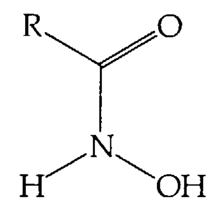

terminal position

R and R' can be organic groups. R and R' can be every possible sequence of C, N, O or S atoms linked to each other by single, double or triple bonds such that the complexing properties of the final chelating agent are assured.

R and R' can be selected from the group comprising organic side chains, heterocycles and aromatic structures.

Said organic side chain is every possible sequence of carbon, atoms linked to each other by a single, double or triple bound and optionally characterized by the presence of functional groups linked to the carbon atoms. Functional groups can be alcohol, carboxyl, carbonyl, aldehyde, keton, ether, ester, amine, amide, halogen containing groups.

Said heterocycle can be on of the group comprising a crown ether, a cryptant, a calixarene, ...

The hydroxamate groups can be linked to the organic side chain, to the heterocyclic or aromatic core of the compound by methylene or polymethylene groups.

A possible example of an chelating agents is given below :

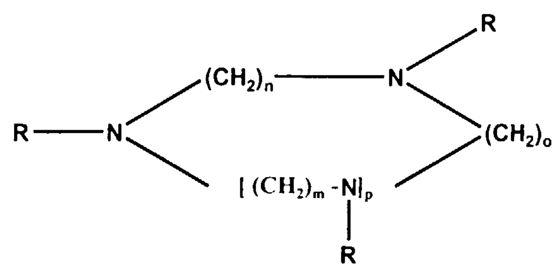

**Cryptand**

**m, n, o** = 2 or 3
**p** = 1 or 2
**R** = organic side chain containing non-terminal or terminal hydroxamate group

Chelating agents containing hydroxamate groups are known for their capability to form extremely stable complexes with metals like iron and aluminum. Furthermore, hydroxamate groups provide good solubility of the organic compound in aqueous solutions and are very stable against oxidizing agents contained in the cleaning solution.

The weight concentration of the CA molecule in the cleaning solution is typically but not limited to lppb-1000ppm, 0.1-100 ppm, 1-50 ppm and 10-20 ppm

The chelating agent can be added directly to the cleaning solution or can first be added to the alkaline compound or the oxidizing compound and than be added to the cleaning solution.

Said cleaning solution can further comprise other chelating agents. The chemical formula of these CA molecule can be different from the chemical formula given above. This means that said other chelating agents can additionally complex metallic impurities.

Said oxidizing compound can be every chemical compound having oxidizing properties. E.g. organic species, metallic particles, silicon,... can be oxidized.

The oxidizing compound is a compound selected from the group comprising hydrogen peroxide or oxidizing anions. The oxidizing anions can be e.g. nitric acid and its salts, nitrate, persulfate, periodate, perbromate, perchlorate, iodate, bromate and chlorate salts of ammonium. Preferably, the oxidizing compound is hydrogen peroxide.

The concentration of the oxidizing compound in said cleaning solution is typically but not limited to 0.01-30 %, 0.1-30 %, 0.1 -20 %. For $H_2O_2$, the weigth concentration range is typically 0.1-10 %. For other oxidizing compounds, the weight concentration range is equivalent, and function of the strength of the oxidizing compound.

In the preferred embodiment of this invention, a cleaning solution for treating a semiconductor surface comprises ammonium hydroxide, hydrogen peroxide, water and a chelating agent. Said chelating agent consists of three hydroxamate groups in non-terminal positions, produced in nature by bacteria Desferrioxamine (see figure 1 a and b). This chelating agent is also available as commercial product (Desferal® from Novartis/Switzerland). The volume mixing ratio of $NH_4OH$(29%)/$H_2O_2$(30%)/$H_2O$ is 0.25/1/5. The cleaning solution is prepared with the amounts as described above and afterwards the semiconductor substrate is treated with the cleaning solution.

It is a further aim of the invention to disclose a process for treating a semiconductor substrate comprising the steps of

- treating said semiconductor substrate with the cleaning solution as described above and
- drying said semiconductor substrate.

An optional step:

- rinsing said semiconductor substrate can be performed after said treating said semiconductor substrate with the cleaning solution as described above.

In the step of treating said semiconductor substrate with said cleaning solution, the semiconductor substrate can be immersed in a bath containing the cleaning solution. Alternatively, the semiconductor substrate can be treated with the cleaning solution by using a spray processor.

The temperature range for treating the semiconductor substrate with the cleaning solution is typically but not limited to 0-95 degrees Celsius, 10-80 degrees Celsius and preferably between 20-70 degrees Celsius.

In the step of drying the semiconductor substrate, several techniques known in the art can be used, e.g. spin-drying, maragoni-drying, drying techniques using organic vapors.

The step of rinsing the semiconductor substrate comprises treating the semiconductor substrate with DI water or treating the semiconductor substrate with a diluted acidic solution.

It is a further aim of the invention to describe a process for treating a semiconductor substrate comprising the steps of:

- treating said semiconductor substrate with any cleaning solution
- treating said semiconductor substrate with any rinsing solution.

Said any cleaning solution can be any alkaline cleaning solution. Said cleaning solution is not limited to the cleaning solutions described in this application. Said rinsing solution comprises said chelating agent and water.

No additional alkaline compound will be added to the said rinsing solution. The pH range of said rinsing solution can typically be, but not limited to, between 5 and 8.

The process of treating a semiconductor substrate with a cleaning solution comprising the above mentioned steps can be performed for a certain number of semiconductor substrates. After treating at least one substrate, but preferably after treating more substrates, the composition of the cleaning solution can be modified by e.g. adding extra alkaline compound, adding extra chelating compound, adding oxidizing compound such that the initial composition of the cleaning solution is kept constant as function of the process time.

The present invention will be further described using non-limiting examples and drawings.

The effectiveness of the new class of chelating agents on the inhibition of the metal catalyzed decomposition of peroxide and the prevention of metal outplating on silicon wafers in metal contaminated APM cleaning solutions is described next. As a model compound of the new class of chelating agents containing polyhydroxamate functional groups, Desferal was chosen and a comparison is made with other types of chelating agents containing as functional groups either phosphonic acids, such as Diethylene triamine penta-methylenephosphonic acid (DTPMP), or carboxylic acids, such as ethylene diamino tetra acetic acid (EDTA). An overview of the different chemicals used for the experiments is given in Table 1.

Table 1:

| Chemicals used for preparation of APM baths. | | |
|---|---|---|
| Chemical | Vendor | Grade |
| $H_2O_2$ 30 (w/w)% | Ashland | TB(*) |
| $NH_4OH$ 29 (w/w)% | Ashland | TB(*) |
| EDTA | Fluka | |
| DTPMP | Monsanto | Dequest 2060S |
| Desferal | Novartis | |

(*) TB-grade corresponds with a specification of maximal 100 ppt of metal ions in the chemical.

**Example 1: Metal outplating from APM mixtures in presence of different complexing agents**

The efficiency of complexing agents to suppress the deposition of metallic contamination onto wafer surfaces was studied. This was done through intentionally spiking well-controlled trace amounts of metallic contamination to cleaning solutions. For these metal deposition tests, p-type monitor wafers with a diameter of 150 mm and <100> orientation were used. The wafers were pre-cleaned using IMEC clean in an automated Steag wet bench (*i.e.* SOM + dHF + $O_3$-rinse rendering a perfectly clean hydrophilic surface).

The metal deposition experiments were performed in a static quartz tank with a quartz cover plate. This tank was not equipped with a megasonic transducer. APM mixtures were prepared containing 1 w-ppb of different metals of interest with/without the complexing agent added. The metals spiked to the APM bath were added from AAS-standard solutions (Merck). After a bath age of 5 minutes, three wafers were immersed for 10 minutes, rinsed for 10 minutes in an overflow rinse tank and dried with a spin drier (Semitool). The resulting metal contamination was measured with straight TXRF or VPD-DSE-DC-TXRF (Vapor Phase Decomposition - Droplet Surface Etching - Droplet Collection Total X-Ray Fluorescence). Determination of Al wafer surface concentration was done using VPD-DC GF-AAS (Graphite Furnace Atomic Absorption Spectroscopy).

An overview of the resulting metal surface contamination after dipping a clean wafer in an APM spiked with metals and different complexing agents is given in Table 2.

Table 2:

| Resulting metal surface concentration after immersion in metal contaminated APM (0.25/1/5) at different temperatures (50 - 70 °C) with different complexing agents present. | | | |
|---|---|---|---|
| Complexing agent (w-ppm) | Metals added (w-ppb) | Al ($10^{10}$ at/cm$^2$) | Fe ($10^{10}$ at/cm$^2$) |
| None | 0 | NM | $2.9 \pm 0.6$ |
| None | 0 | $39.3 \pm 6$ | $1.5 \pm 0.4$ |
| None | 0 | $15 \pm 2$ | NM |
| None | 1 | NM | $162 \pm 5$ |
| None | 1 | $312 \pm 9$ | NM |
| 1 EDTA | 1 | NM | $25.1 \pm 0.1$ |
| 10 EDTA | 1 | $272 \pm 16$ | NM |
| 1 EDTA + 2 DTPMP | 1 | $257 \pm 2$ | <DL |
| 15 Desferal | 1 | $11.5 \pm 0.18$ | $1.33 \pm 0.02$ |

These data show the addition of EDTA as CA results in a slight decrease of the final Fe contamination levels but has almost no effect on reduction of Al contamination. The use of DTPMP in a 1 w-ppb metal spiked bath, is very efficient to reduce the final Fe surface concentration but has no effect on suppression of Al deposition.

The addition of Desferal is shown to result in a strong reduction of the final deposited Fe concentration and is also efficient for the inhibition of Al outplating from metal contaminated APM.

**Example 2: Decomposition of peroxide in APM cleaning mixtures in presence of trace metal contamination and metal complexing agents.**

The effect of the addition of a complexing agent to APM cleaning solutions on the kinetics of the decomposition reaction of $H_2O_2$ has been investigated. Well controlled amounts of metallic contamination were added to the cleaning mixture under study.

As hydrogen peroxide decomposes, an amount of oxygen gas is liberated following the overall reaction

$$2\ H_2O_2 \leftrightarrow O_2 + 2\ H_2O$$

The decay of the total peroxide concentration in the APM mixture can be monitored by measuring the time-dependent increase of the pressure due to the $O_2$-evolution in a dedicated set-up as described by Schmidt.

Numerical integration over time yields the actual peroxide concentration in the bath. It is convenient to use peroxide concentrations normalized to its initial value $[H_2O_2]_i$ as

$$[H_2O_2]_n = \frac{[H_2O_2]}{[H_2O_2]_i}$$

Since the decomposition reaction is mainly catalyzed by Fe and in a lesser content Cu (Mertens *et al.,* 1997), the decay of peroxide concentration in a metal contaminated bath and in presence of a CA, illustrates the ability of chelating primarily Fe in the APM bath.

The decomposition rate as function of bath age is determined in APM mixtures (0.25/1/5 29%$NH_4OH$/30% $H_2O_2$/$H_2O$) spiked with 1 w-ppb of the metals of interest with and without different complexing agents. The effect of different additives on the inhibition of the metal catalyzed decomposition reaction of peroxide in APM cleaning mixtures is shown in Figure 2. This graph shows the normalized $H_2O_2$ concentration as function of bath age for an APM mixture at 50 °C spiked with different complexing agents and the metals of interest.

All complexing agents are found to suppress to some extent the decomposition reaction, at least when the mixture is fresh. For some CA, the suppression action vanishes over time. This may be attributed to the destruction of the complexing agent or more specifically of the metal-complex in the hot APM. The time over which they remain active in complexing metals is summarized in Table 3 and can be used to establish the effective lifetime of the metal contaminated bath. These data show that EDTA has a minor effect on prolonging the lifetime of the bath in presence of trace metal contamination. When we use Desferal in a metal spiked APM, the effect on suppressing the decomposition of peroxide is more pronounced: Fig. 2 shows that by adding 15 w-ppm Desferal to a metal contaminated SC1 at 50°C the decomposition is suppressed for at least 4 hours. After this period of time, the effect of Desferal has disappeared and the decomposition rate starts to increase. However, at 50 °C, the effective lifetime of the bath is very reasonable for application in APM cleaning chemistries.

Table 3:

| Effective lifetime of complexing agents in 0.25/1/5 metal spiked APM-cleaning mixtures at 50 °C. | |
|---|---|
| Complexing agent | Effective lifetime (min) |
| - | 60 |
| 1 w-ppm EDTA | '120' |
| 15 w-ppm Desferal | 280 |

## Claims

1. A cleaning solution for treating a semiconductor substrate , said cleaning solution comprising an alkaline compound, water and a chelating agent comprising at least one group with the chemical formula

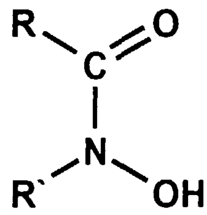

with R and R' selected from the group comprising H and any organic group.

**2.** A cleaning solution such as in any of the claims 1, characterised in that the chelating agent comprises at three groups with the chemical formula

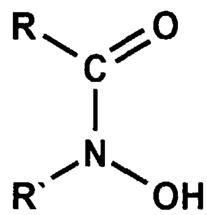

with R and R' selected from the group comprising H and any organic group.

**3.** A cleaning solution such as in claim 1 or 2, characterised in that the organic group is selected from the group consisting of H, an organic side chain, a heterocycle or an aromatic structure.

**4.** A cleaning solution such as in any of the claims 1 to 3, additionally comprising an oxidizing compound.

**5.** A cleaning solution such as in claim 4, characterised in that said oxidizing compound is hydrogen peroxide.

**6.** A cleaning solution such as in claim 5, characterised in that the weight concentration of the hydrogen peroxide in the solution lies between 0.01 to 30%.

**7.** A cleaning solution such as in any of the claims 1 to 6, characterised in that the alkaline compound is chosen from the group consisting of organic base, ammonia, ammonium hydroxide, tetramethyl ammonium hydroxide or an alkaline solution containing metal ions or a combination thereof.

**8.** A cleaning solution such as in any of the claims 1 to 7, characterised in that the weight concentration of the chelating agent lies between 0.01 and 20 %.

**9.** A cleaning solution such as in any of the claims 1 to 8, characterised in that the weight concentration of said chelating agent in said cleaning solution lies between 1 ppt and 1000 ppm.

**10.** A cleaning solution such as in any of the claims 1 to 9, characterised in that the weight concentration of said chelating agent in said cleaning solution lies between 1 ppt and 1000 ppm.

**11.** A cleaning solution such as in any of the claims 1 to 10, characterised in that said cleaning solution comprises ammoniumhydroxide, water and desferrioxamine and possibly hydrogen peroxide.

**12.** A process for treating a semiconductor substrate comprising the steps of

- treating said semiconductor substrate with the cleaning solution of any of the claims 1 to 11, and
- drying said semiconductor substrate.

**13.** A process for treating a semiconductor substrate such as in claim 12, comprises the additional step of rinsing said

semiconductor substrate, wherein said rinsing is performed after step of said treating a semiconductor substrate with said cleaning solution.

**14.** A process for treating a semiconductor substrate such as in claim 12 or 13 , characterised in that said process is performed at a temperature between 5 and 85 degrees Celsius.

**15.** A process for treating a semiconductor substrate such as in any of the claims 12 to 14, characterised in that said process is performed at 50 degrees Celsius.

**16.** A process for treating a semiconductor substrate comprising the steps of:

- treating said semiconductor substrate with any cleaning solution
- treating said semiconductor substrate with a rinsing solution,

characterised in that said cleaning solution can be any alkaline cleaning solution and said rinsing solution comprises a chelating agent such as in claim 1 and water.

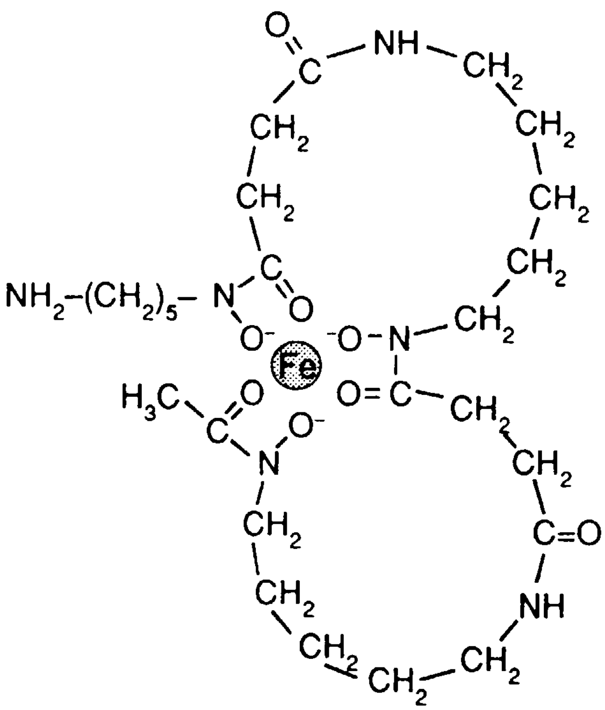

Fig. 1 a

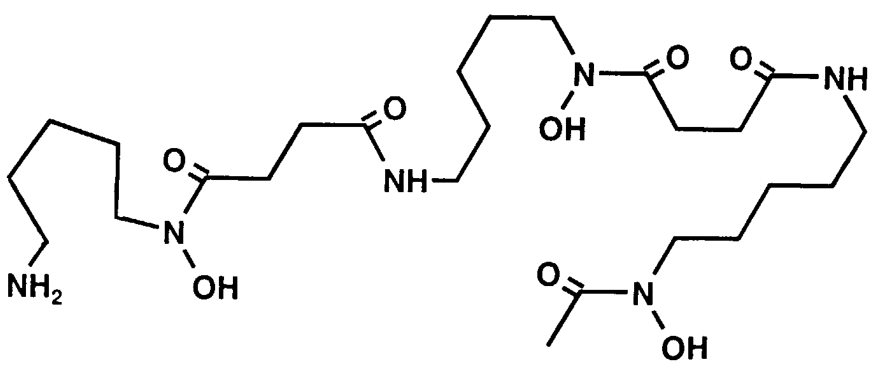

Fig. 1 b

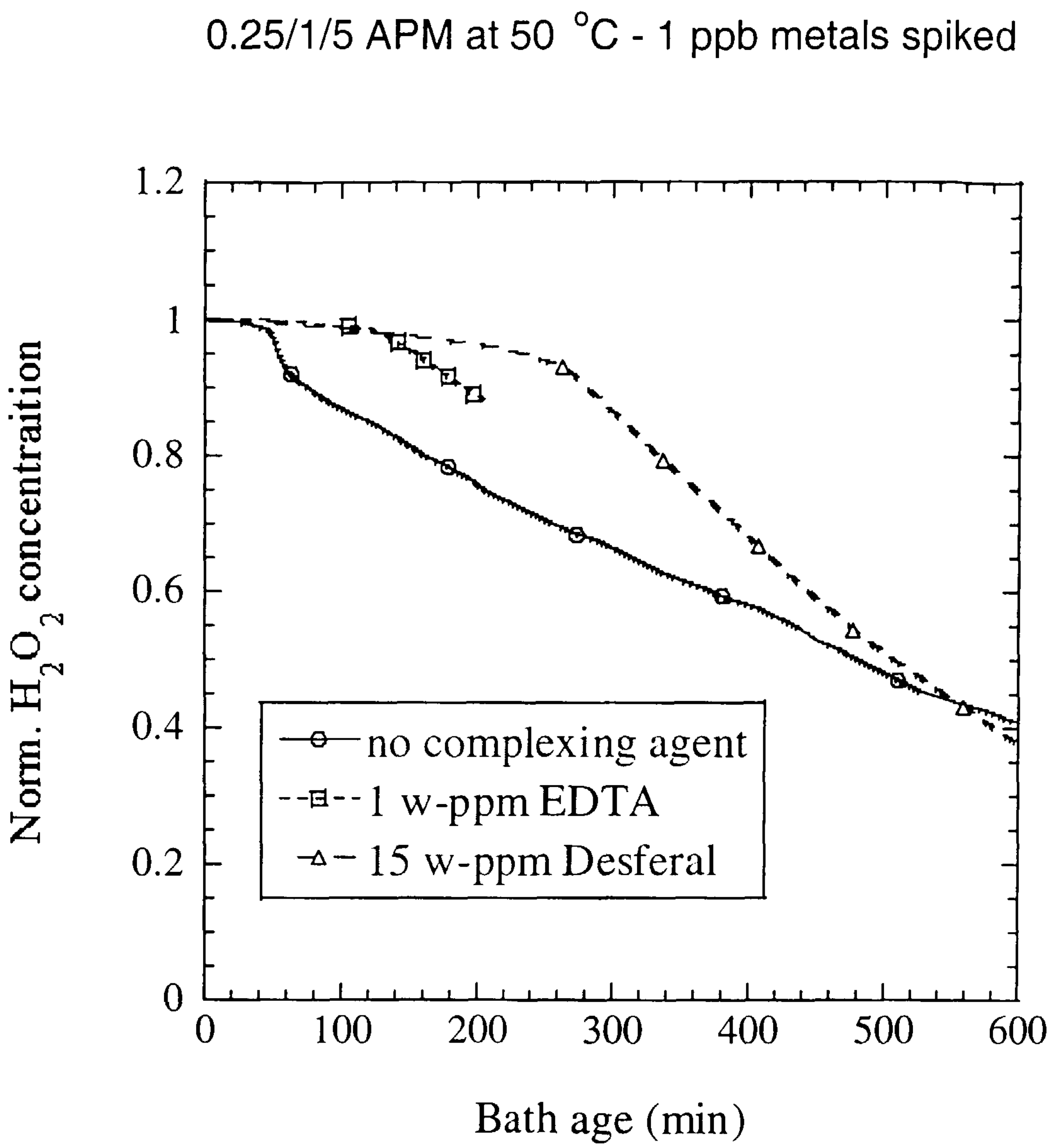
0.25/1/5 APM at 50 °C - 1 ppb metals spiked
1.2
1
0.8
0.6
0.4
0.2
0
0
100
200
300
400
500
600
Norm. H2O2 concentraition
Bath age (min)
no complexing agent
1 w-ppm EDTA
15 w-ppm Desferal

Fig. 2

European Patent Office

# EUROPEAN SEARCH REPORT

Application Number
EP 99 87 0203

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 665 582 A (WAKO PURE CHEM IND LTD) 2 August 1995 (1995-08-02) * page 2, line 3 - line 10 * * page 3, line 39 - page 4, line 5 * * page 5, line 9 - page 6, line 47; examples 1,5,6 * * page 13, line 5 - line 23; claims 1,3-5,7-10 * | 1-14,16 | H01L21/306 B08B3/08 C11D7/26 C11D7/32 |
| Y | | 15 | |
| X | & DATABASE CAPLUS [Online] STN AN 1995:818746, DN 123:244252, 1995 ICHIRO HAASHIDA ET AL.: "Surface treating agents and process for semiconductors" see structures formulas * abstract * --- | 1-14,16 | |
| Y | EP 0 784 336 A (IMEC VZW ;TEXAS INSTRUMENTS INC (US)) 16 July 1997 (1997-07-16) * column 2, line 10 - line 16 * * column 3, line 3 - column 21 * * column 5, line 11 - line 39 * | 15 | |
| A | --- | 12-14,16 | |
| | -/-- | | |

TECHNICAL FIELDS SEARCHED (Int.Cl.7)

H01L
C11D
B08B

The present search report has been drawn up for all claims

| Place of search | Date of completion of the search | Examiner |
|---|---|---|
| BERLIN | 1 March 2000 | Klopfenstein, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

European Patent Office

# EUROPEAN SEARCH REPORT

Application Number
EP 99 87 0203

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN vol. 018, no. 271 (C-1203), 24 May 1994 (1994-05-24) & JP 06 041773 A (TOSHIBA CORP), 15 February 1994 (1994-02-15) * abstract * | 1,3-10 | |
| A | | 11-16 | |
| X | & DATABASE CAPLUS [Online] STN HACHIRO HIRATSUKA et al., 1994 AN 1994:619390, DN 121:219390: "Semiconductor wafer-cleaning solutions" See structures formulas * abstract * --- | 1,2 | |
| A | MARTIN A R ET AL: "Alkaline cleaning of silicon wafers: additives for the prevention of metal contamination" MICROELECTRONIC ENGINEERING,NL,ELSEVIER PUBLISHERS BV., AMSTERDAM, vol. 45, no. 2-3, July 1999 (1999-07), pages 197-208, XP004173788 ISSN: 0167-9317 * page 197, paragraph 1 - page 202, paragraph 3; figures 1-3 * --- | 1-16 | TECHNICAL FIELDS SEARCHED (Int.Cl.7) |
| D,A | US 5 302 311 A (SUGIHARA YASUO ET AL) 12 April 1994 (1994-04-12) * column 1, line 6 - line 24 * * column 2, line 1 - line 68 * --- | 1,4-10, 12-14,16 | |
| D,A | US 5 290 361 A (HAYASHIDA ICHIRO ET AL) 1 March 1994 (1994-03-01) * column 1, line 6 - line 18 * * column 4, line 19 - column 5, line 54; figure 1 * * column 6, line 17 - column 7, line 18 * * column 7, line 61 - column 8, line 14 * ----- | 1,4-10, 12-14,16 | |

The present search report has been drawn up for all claims

| Place of search | Date of completion of the search | Examiner |
|---|---|---|
| BERLIN | 1 March 2000 | Klopfenstein, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 99 87 0203

This annex lists the patent family members relating to the patent documents cited in the above-mentioned European search report.
The members are as contained in the European Patent Office EDP file on
The European Patent Office is in no way liable for these particulars which are merely given for the purpose of information.

01-03-2000

| Patent document cited in search report | | Publication date | Patent family member(s) | | | Publication date |
|---|---|---|---|---|---|---|
| EP 0665582 | A | 02-08-1995 | JP | 7254581 | A | 03-10-1995 |
| | | | US | 5580846 | A | 03-12-1996 |
| | | | US | 5840127 | A | 24-11-1998 |
| EP 0784336 | A | 16-07-1997 | JP | 9275084 | A | 21-10-1997 |
| JP 06041773 | A | 15-02-1994 | NONE | | | |
| US 5302311 | A | 12-04-1994 | JP | 6116770 | A | 26-04-1994 |
| | | | DE | 69207303 | D | 15-02-1996 |
| | | | DE | 69207303 | T | 15-05-1996 |
| | | | EP | 0528053 | A | 24-02-1993 |
| | | | WO | 9216017 | A | 17-09-1992 |
| US 5290361 | A | 01-03-1994 | CA | 2059841 | A | 25-07-1992 |
| | | | EP | 0496605 | A | 29-07-1992 |
| | | | JP | 5275405 | A | 22-10-1993 |
| | | | JP | 10321590 | A | 04-12-1998 |

EPO FORM P0459

For more details about this annex : see Official Journal of the European Patent Office, No. 12/82